# EUROPEAN PATENT APPLICATION

(11) **EP 4 790 727 A1**
(43) Date of publication of application: **12.08.2026**
(21) Application number: 26157806.6
(22) Date of filing: 11.02.2026
(51) Int. Cl.: H01B 1/22, B22F 1/00, H10F 77/20

(54) **SILVER-COATED NICKEL PASTE, PREPARATION METHOD THEREOF, AND HIGH-TEMPERATURE SINTERING METALLIZATION METHOD FOR CRYSTALLINE SILICON SOLAR CELLS**

(30) Priority: 11.02.2025 CN 202510149201
(71) Applicant: Suzhou Xinghan New Material Technology Co., LTD, Suzhou City Jiangsu Province 215200 (CN)
(72) Inventor: SUN, Guanghui, Suzhou City, 215200 (CN); LIU, Cheng, Suzhou City, 215200 (CN); ZENG, Junliang, Suzhou City, 215200 (CN); ZHANG, Meng, Suzhou City, 215200 (CN); ZHANG, Hanlu, Suzhou City, 215200 (CN)
(74) Representative: Palladino, Saverio Massimo

(57) **Abstract**

The present application relates to the field of conductive paste and discloses a silver-coated nickel paste and a preparation method thereof, as well as a high-temperature sintering metallization method for crystalline silicon solar cells. The silver-coated nickel paste includes the following components by weight percentage: 80-95% of conductive powder, consisting of silver-coated nickel powder and micron-sized silver powder; 1-6% of glass powder; 0.1-3% of organic resin; 0.5-0.8% of a thixotropic agent; 0-1% of other auxiliaries and balance is solvent. Among them, the conductive powder is a mixture of silver-coated nickel powder and silver powder at a weight ratio of 1:(0-50). The silver-coated nickel powder used has a resistivity of ≤ 96 µΩ·cm, an oxidation-resistant resistivity of ≤ 205 µΩ·cm, and a titrated nickel content of ≤ 0.01 mol/L. When the silver-coated nickel paste is used for single-backside printing the crystalline silicon solar cells, compared with pure silver paste, the line resistance is slightly higher, the contact resistance is substantially the same, and the printed wet weight is substantially the same. After adjustment, the photoelectric conversion efficiency is 0%-2% lower than that of pure silver paste, and the silver-coated nickel paste can be used as a substitute for pure silver powder paste for crystalline silicon solar cells. Correspondingly, the present application discloses a preparation method of a silver-coated nickel paste and a high-temperature sintering metallization method for crystalline silicon solar cells.

## Description

### TECHNICAL FIELD

The present application relates to the technical field of conductive paste, and in particular relates to a silver-coated nickel paste, a preparation method thereof, and a high-temperature sintering metallization method for crystalline silicon solar cells.

### BACKGROUND ART

At present, the metallization of crystalline silicon solar cells is mainly carried out by screen printing a silver paste, followed by drying, high-temperature sintering, and other process steps. Due to the high silver content in the paste, the cost for the metallization process of crystalline silicon solar cells is relatively high.

In order to reduce the silver content in the paste, silver-coated nickel powder is used to partially replace silver powder to make the paste in related technologies. CN118367063A discloses a TOPcon solar cell metallization method using the silver-coated nickel paste and a solar cell, wherein the silver-coated nickel conductive paste used contains 25-95% of silver-coated nickel powder, 0-70% of silver powder, 1-6% of glass powder, 0.1-3% of organic resin, 0.1-1% of dispersing agent, 0-5% of nickel diffusion regulator, and a balance is solvent. Free nickel is formed during the metallization process of such a paste, and the Nickel is easily oxidized to nickel oxide during the high-temperature sintering metallization process of TOPcon solar cells, increasing the line resistance of TOPcon solar cells, thereby limiting the improvement of the conversion efficiency of TOPcon solar cells. During the metallization process, nickel diffusion regulators and secondary laser sintering are relied upon to form nano-nickel tunneling layers, preventing the formation of large-sized nickel metal particles and nickel "dead layers" that would affect the photoelectric conversion efficiency of the solar cells.

However, the amount of free nickel generated during the metallization process lacks controllability, and the effectiveness of the nickel diffusion regulators cannot completely prevent or eliminate the adverse effects caused by the free nickel.

### SUMMARY

The purpose of the present application is to provide a silver-coated nickel paste, a preparation method thereof, and a high-temperature sintering metallization method for crystalline silicon solar cells.

In the present application, unless otherwise specified, "oxidation-resistant resistivity" refers to the resistivity obtained by testing the powder after calcination at 180°C for 10 min, and the "titrated nickel content" is tested in accordance with the method recorded in Chinese Patent Application No. CN118961994A. A lower titrated nickel content indicates better compactness of the silver coating layer. The specific test steps are as follows:
(1) 2.00 g (with an error of ≤ 0.001 g) of silver-coated nickel powder is accurately weighed and added into a clean 50-mL centrifuge tube.
(2) 30 g of a dilute sulfuric acid solution with a mass fraction of 3% and 800 µL of a hydrogen peroxide solution with a mass fraction of 20% are added into the above centrifuge tube. The centrifuge tube is capped and vibrated on an oscillator to obtain a mixed solution; wherein, the oscillator is opetated at a frequency of 300 r/min for 5 min;
(3) After completion of the oscillation, the centrifuge tube is rapidly transferred to a centrifuge for centrifugation (with proper balancing). The centrifugation speed is set to 6,000 rpm. The above procedures are required to be completed rapidly. After centrifugation, the supernatant in the centrifuge tube is collected and transferred into a new centrifuge tube for subsequent use.
(4) 20 mL of the supernatant of the above mixed solution is accurately pipetted into a 250-mL Erlenmeyer flask, and 50 mL of deionized water is added, followed by uniform shaking. Subsequently, 19 mL of an ammonium chloride buffer solution and 0.01 g of murexide indicator are added into the Erlenmeyer flask by using a dispenser, and the mixture is shaken uniformly until the solution turns bright yellow, thereby obtaining a solution to be tested.
(5) An ethylenediamine tetraacetic acid disodium salt standard solution with a concentration of 0.05 mol/L is filled into a burette to a scale of 10 mL. The solution to be tested is titrated at a low speed with the 0.05 mol/L ethylenediamine tetraacetic acid disodium salt standard solution. When the color of the solution to be tested turns purple, the titration is stopped. If the color does not turn back to the original color after shaking for 30 s, it is determined as the titration endpoint. The volume of the 0.05 mol/L ethylenediamine tetraacetic acid disodium salt standard solution consumed in the titration is recorded.
(6) Calculation of titration result: The calculation formula is c=V1 *C1/V. In the formula,
   c: content of free nickel, in mol/L;
   C1: concentration of ethylenediamine tetraacetic acid disodium salt standard solution, in mol/L;
   V1: volume of ethylenediamine tetraacetic acid disodium salt standard solution consumed in the titration, in mL;
   V: volume of the taken supernatant of the mixed solution, in mL.

In the first aspect, the present application provides a silver-coated nickel paste, adopting the following technical solution:
A silver-coated nickel paste, including the following components by weight percentage:
80-95% of a conductive powder,
1-6% of a glass powder,
0.1-3% of an organic resin,
0.5-0.8% of a thixotropic agent,
0-1% of other auxiliaries, and
a balance is solvent;
wherein, the conductive powder is a mixture of silver-coated nickel powder and silver powder at a weight ratio of 1:(0-50); the silver-coated nickel powder used has a resistivity of ≤ 96 µΩ·cm, an oxidation-resistant resistivity of ≤ 205 µΩ·cm, and a titrated nickel content of ≤ 0.01 mol/L.

Furthermore, the silver content in the silver-coated nickel powder is 5 wt%-50 wt%.

Furthermore, the silver content in the silver-coated nickel powder is 5 wt%-25 wt%.

Furthermore, the silver-coated nickel powder is subjected to surface modification treatment, with the specific steps as follows:
by adopting a dry modification method, uniformly mixing a surface modifier in an mount of 0.05% to 0.5% based on the weight of the silver-coated nickel powder , with the silver-coated nickel powder, to obtain the surface-modified silver-coated nickel powder.

Furthermore, the surface modifier is selected from one or more of terpineol, fatty acid, and dodecylbenzene sulfonic acid.

Furthermore, the particle size of the glass powder is 2-5 µm.

Furthermore, the glass powder is prepared from mixed raw materials through melting, cooling, and ball milling. The mixed raw materials are composed of the following components by weight percentage:
35.3%-46.31% of lead oxide (PbO),
5.38%-13.2% of silicon dioxide (SiO₂),
2.64%-4.16% of lithium oxide (Li₂O),
1.85%-3.5% of zinc oxide (ZnO),
1.22%-1.76% of sodium oxide (Na₂O),
0.43%-2.61% of magnesium oxide (MgO),
0.35%-1.57% of calcium oxide (CaO),
0-30.53% of tellurium oxide (TeO₂),
0-21.72% of barium oxide (BaO),
0-19.55% of boron oxide (B₂O₃),
0-9.65% of tungsten oxide (WO₃), and
0-0.53% of copper oxide (CuO).

Furthermore, the specific preparation steps of the glass powder are as follows: weighing raw materials according to the ratio, mixing the raw materials to obtain a mixture; melting the mixture at 1,250-1,300°C for 1.5 h, and then quenching to obtain glass fragments; grinding and sieving the glass fragments to obtain the glass powder.

Furthermore, during the preparation process of the glass powder, the glass fragments are placed into a 20-L vertical ball mill, into which 15 kg of zirconia spheres with a diameter of 5-10 mm are added, a total of 2 kg of deionized water and oleic acid are added, and the mixture is stirred at a speed of 250 r/min and subjected to ball milling for 8 h to obtain a glass paste. The glass paste is then sieved and dried to obtain glass powder with a particle size of 2-5 µm.

Furthermore, the organic resin is a mixture of one or more of PVB resin, rosin resin, acrylic resin, phenoxy resin, and ethyl cellulose.

Furthermore, the thixotropic agent is a mixture of one or more of polyamide wax, hydrogenated castor oil, and polyethylene glycol.

Furthermore, the other auxiliaries are a mixture of one or more of palmitic acid, a silane coupling agent, dimethyl silicone oil, oleic acid, and a TDO dispersing agent.

Furthermore, the solvent is selected from one or more of tripropylene glycol n-butyl ether, dibutyl phthalate, terpineol, tributyl citrate, butyl carbitol, triethylene glycol monobutyl ether, diethylene glycol monobutyl ether, and benzyl alcohol.

In the second aspect, the present application provides a preparation method of the silver-coated nickel paste, adopting the following technical solution:
A preparation method of the silver-coated nickel paste of any one of the preceding aspect, comprising weighing raw materials according to the ratio, mixing the raw materials preliminarily with a homogenizer, and then rolling with a three-roller mill.

In the third aspect, the present application provides a high-temperature sintering metallization method for crystalline silicon solar cells, adopting the following technical solution:

A high-temperature sintering metallization method for crystalline silicon solar cells, mainly applicable to crystalline silicon solar cells such as PERC, TOPCon and BC that are metallized by high-temperature sintering, wherein the method uses the silver-coated nickel paste described in any one of the preceding aspects. The specific steps are as follows: screen-printing the silver-coated nickel paste on the surface of the crystalline silicon solar cells for high-temperature sintering metallization, drying, and sintering in the air at 500-750°C to complete the high-temperature sintering metallization of crystalline silicon solar cells.

The present application has the following beneficial effects:

The silver-coated nickel conductive paste provided by the present application contains densely coated, highly reliable silver-coated nickel powder and does not contain a nickel diffusion agent. When used in the single-backside printing of crystalline silicon solar cells for high-temperature sintering, compared with pure silver paste, the line resistance is slightly higher, the contact resistance is substantially the same, and the printed wet weight is substantially the same. After adjustment, the photoelectric conversion efficiency is 0%-2% lower than that of pure silver paste, that is, the silver-coated nickel conductive paste can be used as a substitute for pure silver powder paste for the high-temperature sintering of crystalline silicon solar cells.

2. When the silver-coated nickel conductive paste of the present application is used in the high-temperature sintering metallization method for crystalline silicon solar cells, expensive silver is replaced with metallic nickel, effectively reducing the cost of the conductive paste.

### BRIEF DESCRIPTION OF THE DRAWINGS

FIG. 1 shows the SEM image of the silver-coated nickel powder prepared in the Preparation Example;
FIG. 2A and FIG. 2B show the SEM images of the cross-section of the silver-coated nickel electrode after printing and sintering according to Example 2.

### DETAILED DESCRIPTION

In order to enable those skilled in the art to better understand the technical solutions in the present application, the following is a further detailed description of the present application.

### Preparation Examples

### [Preparation of silver-coated nickel powder]

The preparation steps of the silver-coated nickel powder are as follows:
S1. Pretreatment of nickel powder surface: 500 g of micron-sized nickel powder and 2.5 kg of deionized water were added into a beaker and the mixture was stirred evenly to form a suspension. 200 g of sodium bicarbonate was added while stirring, and the beaker was then placed into an ultrasonic bath for ultrasonic cleaning of the nickel powder. Upon sedimentation, the supernatant was discarded to obtain clean nickel powder. 5 kg of deionized water and 200 g of sodium hydroxide were further added and stirred to obtain an activated nickel powder suspension.

S2. Dispersion of nickel powder: at the end of step S1, the supernatant was discarded after sedimentation, obtaining activated nickel powder. Into the activated nickel powder were added 10 kg of deionized water and 200 g of polyethylene glycol 200, and the mixture was stirred evenly to form a nickel powder suspension to be silver-plated.

S3. Preparation of silver-plating solution: 340 g of silver nitrate was weighed and dissolved in 1 kg of deionized water, into which was added 300 mL of concentrated aqueous ammonia to form a complex silver-plating solution.

S4. Silver coating process: The prepared silver-plating solution was added dropwise into the nickel powder suspension obtained in step S2 at a rate of 20 mL/min while stirring. After completion of the dropwise addition, the mixture continued to be stirred and reacted for 30 min, such that silver was chemically plated on the surface of the nickel powder. Subsequently, 300 g of potassium sodium tartrate was added to promote complete reduction and deposition of silver ions on the surface of the nickel powder. After another 30 min of reaction with stirring, the silver coating process was completed.

S5. Washing and drying: at the end of step S4, upon the sedimentation of the plating solution, the supernatant was discarded to obtain silver-coated nickel powder. The silver-coated nickel powder was washed through three separate cycles, each cycle using 2 kg of deionized water, of stirring, washing, and centrifugation, and then washed through two separate cycles, each cycle using 1 kg of absolute ethanol of stirring, washing, and centrifugation, so as to remove residues adsorbed on the surface of the silver-coated nickel powder, thereby obtaining wet and clean silver-coated nickel powder. The wet silver-coated nickel powder was placed in a forced-air drying oven and dried at 70°C for 6 h to obtain about 697 g of clean, spherical silver-coated nickel powder.

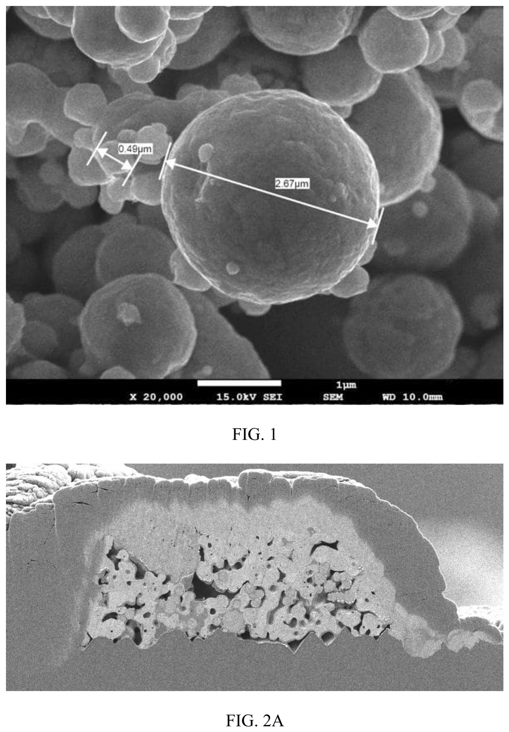

S6. Surface modification: 2 g of terpineol was evenly sprayed onto the 697 g of clean silver-coated nickel powder after drying and then mixed evenly to obtain modified silver-coated nickel powder that can be used to prepare the paste. FIG. 1 shows the SEM image of the prepared silver-coated nickel powder.

Referring to the aforementioned method, several silver-coated nickel powders shown in Table 1 were prepared by adjusting the amount of silver nitrate used, and their resistivity, oxidation-resistant resistivity, and titrated nickel content were measured respectively.

**Table 1. Performance parameters of silver-coated nickel powder**

| Item | Technical indicators | Preparation Example 1 | Preparation Example 2 | Preparation Example 3 | Preparation Example 4 | Preparation Example 5 | Preparation Example 6 |
|---|---|---|---|---|---|---|---|
| Powder morphology | Spherical | Spherical | Spherical | Spherical | Spherical | Spherical | Spherical |
| Resistivity (µΩ·cm) | ≤96 | 49 | 38 | 44 | 32 | 33 | 30 |
| Oxidation-resistant resistivity (µΩ·cm) | ≤205 | 189 | 134 | 164 | 109 | 112 | 98 |
| Silver content | 25%-50% | 25% | 30% | 35% | 40% | 45% | 50% |
| Titrated nickel content (mol/L) | ≤0.01 | 0.0082 | 0.0066 | 0.0075 | 0.0061 | 0.0060 | 0.0053 |

### [Preparation of glass powder]

Raw materials were weighed according to the ratio in Table 2 and mixed to obtain a mixture. The mixture was melted at 1,250-1,300°C for 1.5 h and then poured into deionized water for quenching to obtain glass fragments. After filtering out the water from the glass fragments, the glass fragments were placed into a 20-L vertical ball mill, into which 15 kg of zirconia spheres with a diameter of 5-10 mm were added, a total of 2 kg of deionized water and oleic acid were added, and the mixture was stirred at a speed of 250 r/min and subjected to ball milling for 8 h to obtain a glass paste. Finally, the glass paste was sieved and dried to obtain glass powder with a particle size of 2-5 µm.

**Table 2. Raw material ratio for preparation of glass powder**

| Raw materials | Preparation Example A | Preparation Example B | Preparation Example C |
|---|---|---|---|
| Boron oxide (B₂O₃) | 19.55% | 17.28% | 0 |
| Lead oxide (PbO) | 37.92% | 46.31% | 35.30% |
| Silicon dioxide (SiO₂) | 8.33% | 5.38% | 13.20% |
| Barium oxide (BaO) | 21.72% | 21.72% | 0 |
| Lithium oxide (Li₂O) | 3.85% | 2.64% | 4.16% |
| Sodium oxide (Na₂O) | 1.76% | 1.22% | 1.41% |
| Magnesium oxide | 2.61% | 0.43% | 1.69% |
| Calcium oxide (CaO) | 1.57% | 0.52% | 0.35% |
| Zinc oxide (ZnO) | 2.16% | 1.85% | 3.50% |
| Copper oxide (CuO) | 0.53% | 0 | 0.21% |
| Tungsten oxide (WO₃) | 0 | 2.65% | 9.65% |
| Tellurium oxide | 0 | 0 | 30.53% |

### Examples

### [Examples 1-6]

Raw materials were weighed according to the ratio in Table 3, mixed preliminarily with a homogenizer, and then rolled with a three-roller mill to obtain the silver-coated nickel paste.

**Table 3. Raw material ratio of Examples 1-6**

| Raw materials | Example 1 | Example 2 | Example 3 | Example 4 | Example 5 | Example 6 |
|---|---|---|---|---|---|---|
| Conductive powder | 88% | 89% | 88.4% | 90.5% | 89.8% | 89% |
| Glass powder | Preparation ExampleA | Preparation Example B | Preparation Example A | Preparation Example C | Preparation Example B | Preparation Example C |
| | 3.10% | 2.00% | 3.30% | 2.30% | 4.10% | 3.50% |
| PVB resin | 2.30% | / | / | 1.50% | 1.20% | / |
| Rosin resin | / | 2.10% | 1.20% | / | / | / |
| Acrylic resin | 1.50% | 1.90% | 1.20% | 1% | / | 1.20% |
| Phenoxy resin | / | / | / | / | / | 1% |
| Ethyl cellulose | / | / | 1.30% | 1% | 1.30% | 1.30% |
| Polyamide wax | 0.50% | 0.50% | 0.80% | 0.50% | 0.50% | / |
| Hydrogenated castor oil | 0.60% | / | / | / | / | / |
| Polyethylene glycol | / | / | / | / | / | 0.80% |
| Palmitic acid | / | / | / | 0.3% | / | / |
| Silane coupling agent | / | 0.30% | 0.30% | / | / | 0.30% |
| Dimethyl silicone oil | / | / | / | / | 0.20% | / |
| Oleic acid | / | 0.60% | / | / | / | / |
| TDO dispersing agent | / | / | 0.60% | 0.60% | 0.60% | 0.60% |
| Tripropylene glycol n-butyl ether | 2.80% | / | / | / | / | / |
| Dibutyl phthalate | / | 2.0% | / | / | / | / |
| Terpineol | 1.20% | 1.60% | / | / | / | 1.30% |
| Tributyl citrate | / | / | 1.30% | 1.30% | / | / |
| Butyl carbitol | | / | 1.60% | / | 0.50% | / |
| Triethylene glycol monobutyl ether | | / | / | 1.3% | / | / |
| Diethylene glycol monobutyl ether | / | / | / | / | 1.30% | 1% |
| Benzyl alcohol | / | / | / | / | 0.50% | / |

In Examples 1-6, the glass powders used were all prepared by the method of Preparation Examples; the conductive powders used were a mixture of silver powder and silver-coated nickel powder, and the specific composition of the conductive powders is shown in Table 4.

**Table 4. Composition of conductive powders in Examples 1-6**

| Raw materials | Example 1 | Example 2 | Example 3 | Example 4 | Example 5 | Example 6 |
|---|---|---|---|---|---|---|
| Silver powder particle size | 1 µm | 0.8 µm | 1.3 µm | 0.8 µm | 0.8 µm | 0.8 µm |

| Source of silver-coated nickel powder | Preparation Example 2 | Preparation Example 4 | Preparation Example 1 | Preparation Example 6 | Preparation Example 5 | Preparation Example 3 |
|---|---|---|---|---|---|---|
| | | | | Preparation Example 2 | | |
| Silver-coated nickel powder /silver powder (weight) | 3.4:1 | 1.967:1 | 7.84:1 | 17.1:1 | 4.987:1 | 1.225:1 |

Among them, in Example 4, two types of silver-coated nickel powders with silver contents of 50% (Preparation Example 6) and 30% (Preparation Example 2) respectively were used, and the weight ratio of the two types of silver-coated nickel powders was 2.4:1. In other examples, self-made or commercially available silver-coated nickel powders of other specifications can be selected as raw materials, and one specification of silver-coated nickel powder can be used alone or multiple specifications of silver-coated nickel powders can be blended.

### Comparative Examples

### [Comparative Example 1]

Comparative Example 1 is based on Example 1, and the difference is that the conductive powder is pure silver powder.

### [Comparative Example 2]

Comparative Example 2 is a commercially available pure silver high-temperature conductive paste for the high-temperature sintering of crystalline silicon solar cells, from Heraeus, trade Name SOL3201.

### [Comparative Examples 3-6]

Comparative Examples 3-6 are all based on Example 1, and the only difference is that the specifications of the silver-coated nickel powder in the conductive powder are different, specifically as shown in Table 5.

**Table 5. Specification of silver-coated nickel powder of Comparative Examples 3-5**

| Silver-coated nickel powder | Comparative Example 3 | Comparative Example 4 | Comparative Example 5 |
|---|---|---|---|
| Powder morphology | Spherical | Spherical | Spherical |
| Resistivity/µΩ·cm | 101 | 107 | 103 |
| Oxidation-resistant resistivity/µΩ·cm | 381 | 407 | 396 |
| Silver content | 30% | 30% | 30% |
| Titrated nickel content/mol/L | 0.0175 | 0.0211 | 0.0197 |

Application Examples and Comparative Application Examples

### [Application Examples 1-6]

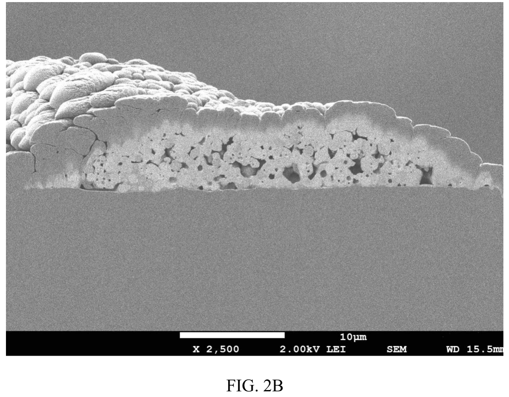

A high-temperature sintering metallization method for crystalline silicon solar cells uses the silver-coated nickel paste of Examples 1-6 respectively. The specific steps are as follows: screen-printing the silver-coated nickel paste on the surface of the crystalline silicon solar cells, drying, and sintering in the air at 500-750°C to complete the metallization of crystalline silicon solar cells. The SEM images of the cross-section of the silver-coated nickel electrode after printing and sintering with the silver-coated nickel paste of Example 2 are shown in FIGs. 2A and 2B.

### [Comparative Application Examples 1-5]

The comparative application examples are different from the application examples in that the pastes of comparative examples 1-5 are used respectively.

### Performance Detection Test

For the high-temperature sintered crystalline silicon solar cells prepared by the metallization processes of Application Examples 1-6 and Comparative Application Examples 1-5 of the present invention, the electrical performance was tested.

### [Detection of Total Wet Weight of Rear Auxiliary Grid]

The weight change of a single 166 mm silicon wafer before and after printing was measured by a differential method. Five wafers were measured and the average value was taken.

### [IV Test]

The solar cells were characterized at 25°C ± 1.0°C using a commercially available IV tester "YP-CX5000" obtained from YP Intelligence. The stroboscopic pulse light simulates sunlight, and its AM1.5 intensity on the cell surface is known to be 1,000 W/m². In order for the simulator to have this intensity, the stroboscopic pulse light flashes several times in a short period of time until a stable level is reached as monitored by the "1.0.0.0" software of the IV tester. The YP IV tester uses a multi-point contact method to measure current (I) and voltage (V) to determine the IV curve of the cell. All values are automatically determined from the curve with the aid of a running software package. As a reference standard, a calibrated solar cell obtained from ISE Freiburg and made of the same wafer material with the same area size, and using the same front pattern was tested, and the data was compared with the certified values. At least 20 wafers processed in the same way were measured, and the data was analyzed by calculating the average of the values. The software provides values for conversion efficiency and line resistance.

### [Contact resistance]

All equipment and materials were balanced in an air conditioning room at a temperature of 22 ± 1°C before measurement. In order to measure the contact resistance of the fired electrode on the doped front layer of the silicon solar cell, the MLR-5104 on-resistance test system was used. The equipment applied the 4-point measurement principle to estimate the contact resistance using the transfer length method (TLM). In order to measure the contact resistance, two strips each having a width of 1 cm were cut out of the wafer perpendicular to the printed grid lines of the wafer. The exact width of each strip was measured with an accuracy of 0.05 mm. The width of the fired secondary grid lines was measured at 3 different points on the strip using a digital microscope "VHX-970F" equipped with a wide-range zoom lens VH-Z250 from Keyence Corp. The width was measured 10 times at each point with 2-point measurements. The grid line width value was the average value of all 30 measurements. The contact resistance was calculated by the software package using the pointer number, the strip width and the distance between the printed secondary grids. The measuring current was set to 14 mA. A multi-contact measuring head suitable for contacting 11 adjacent grid lines was installed and brought into contact with the 11 adjacent grid lines. Measurements were performed at 10 equally spaced points distributed on each strip. After initiating the measurement, the software determined the contact resistance value (mohm) at each point on the strips. The average value of all 20 points was taken as the contact resistance value.

The test results are summarized in Table 6.

**Table 6. Performance test results**

| Item | Line resistance | Contact resistance | Wet Weight of Rear Auxiliary Grid | Photoelectric conversion efficiency |
|---|---|---|---|---|
| Application Example 1 | 4.8 mohm | 2.05 mohm | 68 mg | 25.24% |
| Application Example 2 | 3.9 mohm | 1.87 mohm | 70 mg | 25.36% |
| Application Example 3 | 4.3 mohm | 1.93 mohm | 69 mg | 25.30% |
| Application Example 4 | 3.3 mohm | 2.45 mohm | 71 mg | 25.36% |
| Application Example 5 | 3.2 mohm | 1.85 mohm | 67 mg | 25.41% |
| Application Example 6 | 3.0 mohm | 1.75 mohm | 66 mg | 25.43% |
| Comparative Application Example 1 | 2.1 mohm | 1.82 mohm | 67 mg | 25.45% |
| Comparative Application Example 2 | 1.9 mohm | 1.75 mohm | 68 mg | 25.49% |
| Comparative Application Example 3 | 25.1 mohm | 2.17 mohm | 68 mg | 24.78% |
| Comparative Application Example 4 | 18.2 mohm | 2.28 mohm | 67 mg | 24.51% |
| Comparative Application Example 5 | 23.4 mohm | 2.21 mohm | 68 mg | 24.64% |

It can be seen from the data in the table above that when the silver-coated nickel paste provided by the present application is used for single-backside printing the crystalline silicon solar cells, compared with pure silver paste, the line resistance is slightly higher, the contact resistance is substantially the same, and the printed wet weight is substantially the same. After adjustment, the efficiency is 0.03%-0.1% lower than that of pure silver paste. That is, it is feasible to replace the pure silver powder in the silver paste of crystalline silicon solar cells with a dense-coated, highly reliable silver-coated nickel powder. When the silver-coated nickel paste of the present application is used for the metallization of crystalline silicon solar cells, no secondary laser sintering is required.

The above are merely preferred embodiments of the present application and are not intended to limit the scope of protection of the present application. Therefore, any equivalent variations made based on the structure, shape, and principles of the present application shall fall within the scope of protection of the present application.

## Claims

1. A silver-coated nickel paste, comprising the following components by weight percentage:
80-95% of a conductive powder,
1-6% of a glass powder,
0.1-3% of an organic resin,
0.5-0.8% of a thixotropic agent,
0-1% of other auxiliaries, and
a balance is solvent;
wherein, the conductive powder is a mixture of silver-coated nickel powder and silver powder at a weight ratio of 1:(0-50); the silver-coated nickel powder used has a resistivity of ≤ 96 µΩ·cm, an oxidation-resistant resistivity of ≤ 205 µΩ·cm, and a titrated nickel content of ≤ 0.01 mol/L.

2. The silver-coated nickel paste according to claim 1, wherein the silver content in the silver-coated nickel powder is 5 wt%-50 wt%.

3. The silver-coated nickel paste according to claim 2, wherein the silver-coated nickel powder is subjected to surface modification treatment, with the specific steps as follows:
by adopting a dry modification method, mixing 0.05% to 0.5% of a surface modifier, based on the weight of the silver-coated nickel powder, with the silver-coated nickel powder uniformly to obtain the surface-modified silver-coated nickel powder.

4. The silver-coated nickel paste according to any one of claims 1-3, wherein the organic resin is a mixture of one or more of PVB resin, rosin resin, acrylic resin, phenoxy resin, and ethyl cellulose.

5. The silver-coated nickel paste according to any one of claims 1-3, wherein the thixotropic agent is a mixture of one or more of polyamide wax, hydrogenated castor oil, and polyethylene glycol.

6. The silver-coated nickel paste according to any one of claims 1-3, wherein the other auxiliaries are a mixture of one or more of palmitic acid, a silane coupling agent, dimethyl silicone oil, oleic acid, and a TDO dispersing agent.

7. The silver-coated nickel paste according to any one of claims 1-3, wherein the solvent is selected from one or more of tripropylene glycol n-butyl ether, dibutyl phthalate, terpineol, tributyl citrate, butyl carbitol, triethylene glycol monobutyl ether, diethylene glycol monobutyl ether, and benzyl alcohol.

8. A preparation method of the silver-coated nickel paste of any one of claims 1-7, comprising weighing the raw materials according to the ratio, mixing uniformly and then rolling to obtain the silver-coated nickel paste to be used for the metallization of crystalline silicon solar cells.

9. A metallization method of crystalline silicon solar cells, using the silver-coated nickel paste of any one of claims 1-7.

10. The metallization method of crystalline silicon solar cells according to claim 9, comprising specific steps of screen-printing the silver-coated nickel paste on the surface of the crystalline silicon solar cells, drying, and sintering in the air at 500-750°C to complete the metallization of crystalline silicon solar cells.
